Europäisches Patentamt

European Patent Office

Office européen des brevets

(11) Publication number: **0 161 896**
A2

## EUROPEAN PATENT APPLICATION

(21) Application number: **85303212.6**

(51) Int. Cl.⁴: **H 02 M 7/21**

(22) Date of filing: **07.05.85**

(30) Priority: **11.05.84 US 609402**

(43) Date of publication of application: **21.11.85**
**Bulletin 85/47**

(84) Designated Contracting States: **DE FR GB IT NL**

(71) Applicant: **SPERRY CORPORATION, 1290, Avenue of the Americas, New York, N.Y. 10019 (US)**

(72) Inventor: **Dickey, John Alvin, 1241 Crocus Street, Palm Bay Florida 32907 (US)**

(74) Representative: **Singleton, Jeffrey et al, ERIC POTTER & CLARKSON 27 South Street, Reading Berkshire, RG1 4QU (GB)**

(54) **Half wave demodulation circuit.**

(57) An electronic circuit for converting an AC voltage input signal to a DC voltage output signal utilises a square wave reference signal (31) for regulating a field-effect transistor (38) to switch on the input signal (30) for a half period, and to switch off the input signal for a half period, whereby ripple current flows through a first filter (43, 45, 47) coupled to the transistor for only a half period, with a steady discharge current through the first filter for the other half period,, thereby reducing ripple. A second filter (46, 49) coupled to the first filter (43, 45, 47) and an operational amplifier (51) further diminish ripple.

0161896

## HALF WAVE DEMODULATION CIRCUIT

The present invention relates generally to electronic circuits, and more particularly to such circuits which generate, from an AC voltage input signal, a DC voltage output signal.

Cost-effective half wave demodulators of the prior art, utilised with a 400 Hz, 6 volt AC input signal, exhibit a ripple level in excess of 10 mv, and variations in output, from unit to unit, in excess of one per cent. The ripple level can be reduced by moving the filter poles to a lower frequency. However, in certain applications, such as servo-mechanisms, that is not practical since additional, destabilising time lag in the signal results.

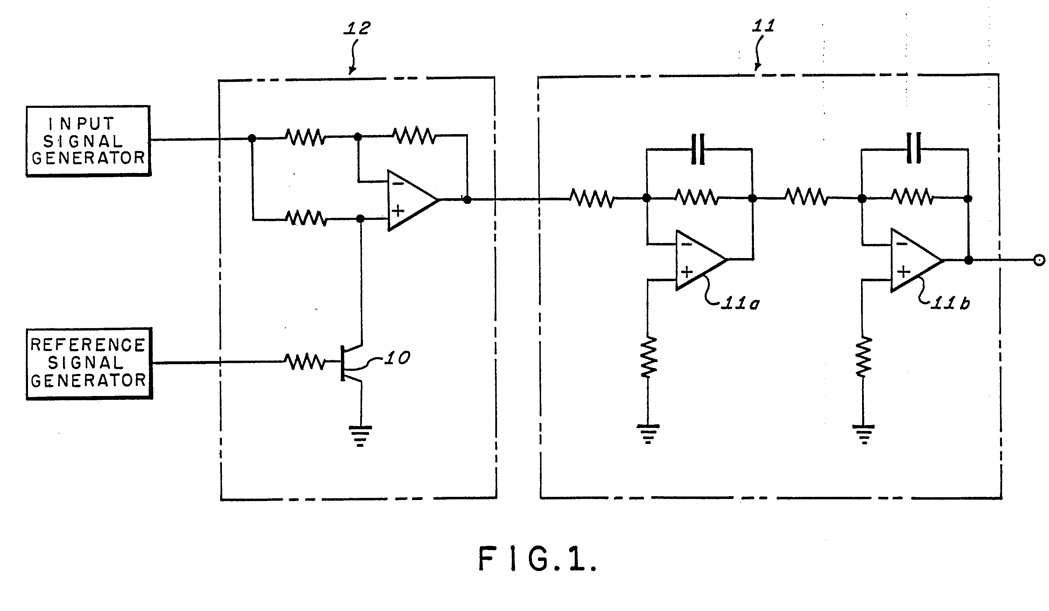

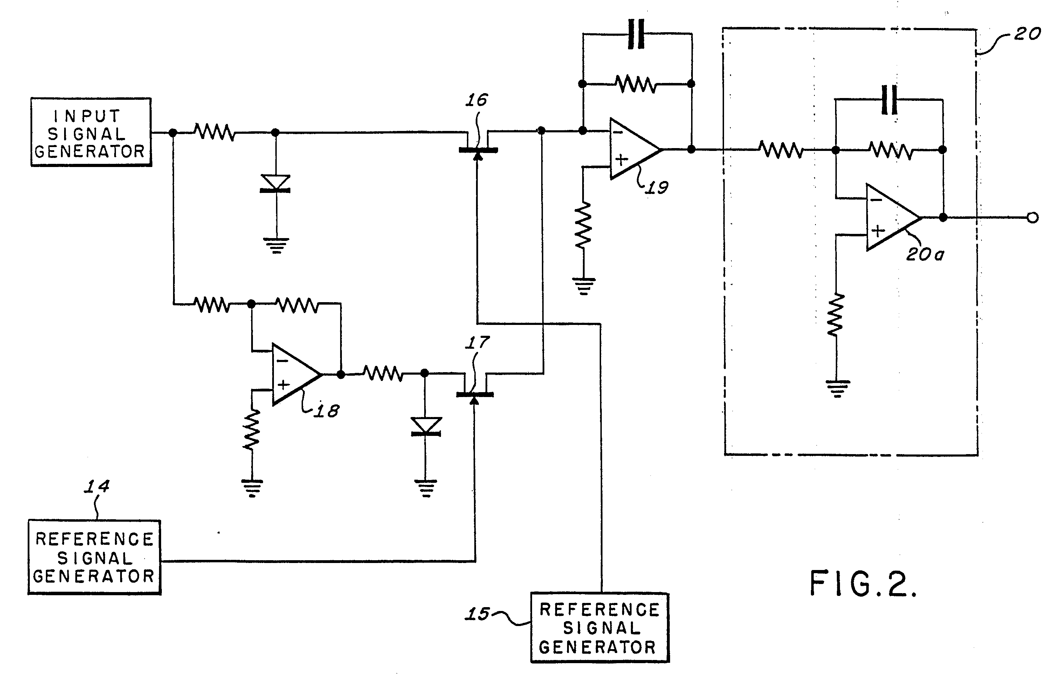

Filter poles at acceptable frequencies, and a low ripple level can be attained with full wave demodulators of the prior art. However, these circuits entail certain disadvantages. Referring to Figure 1 of the accompanying drawings, a known shunt switch full wave demodulator is depicted. Leakage currents in a switching transistor 10, upon being turned off, detract from unit-to-unit performance consistency. Also, two poles of filtering entailing additional operational amplifiers 11a and 11b in a stage 11 are required after a demodulation stage 12, engendering further circuitry and associated errors. Referring to Figure 2 of the accompanying drawings, a known series switch full wave demodulator is depicted. This design possesses superior performance consistency from unit to unit but necessitates two reference signal generators 14 and 15, two switching transistors 16 and 17, and to effect demodulation, two operational amplifiers 18 and 19. Also, a pole of filtering entailing an additional operational amplifier 20a in a stage 20 is required after the demodulation stage, to achieve the desired pole configuration and ripple level.

Thus, there is a need for a relatively simple, inexpensive electronic circuit that converts an AC

0161896

- 2 -

voltage input signal to a DC voltage output signal which varies less than one per cent from unit to unit, and which exhibits less than 10 mv of ripple.

The present invention is defined in the appended claims and entails a half wave demodulation apparatus comprising means for generating an AC voltage input signal having a period comprising a first half period and a second half period. Means having an input terminal coupled to the generating means and having an output terminal, is utilised for switching off the AC voltage input signal during the first half period, and for switching on the AC voltage input signal during the second half period. A first means, having an input terminal coupled to the output terminal of the switching means and having an output terminal, is used for filtering the input signal. A second means for filtering the input signal has an input terminal coupled to the output terminal of the first filtering means. An operational amplifier has an inverting input terminal coupled to the input terminal of the second filtering means, and an output terminal coupled to an output terminal of the second filtering means. A first resistor has a first end coupled to a non-inverting input terminal of the operational amplifier and a second end coupled to ground.

In a preferred embodiment of the present invention, the switching means comprises a field-effect transistor having a source coupled to the input signal generating means. Means is utilised for generating a reference signal having a predetermined first voltage waveform during the first half period, and having a predetermined second voltage waveform during the second half period. A diode has an anode coupled to a gate of the field-effect transistor to form a first junction, and a cathode coupled to the reference signal generating means. A second resistor has a first end coupled to a junction of the input signal generating means and the source of the transistor, and a second end coupled to the first junction.

Each of the filtering means, in a preferred embodiment of the invention, comprises a resistor coupled to a capacitor.

The present invention exhibits the performance consistency of the series full wave design of Figure 2, but entails less ripple. In the series full wave design, ripple current flows in the filters for the entire period of the AC voltage input dignal, whereas in the present invention the switching means is off for half a period and the first filter means during this interval sees only a steady discharge current through a resistor. Thus, the root mean square ripple level is reduced at the first filter means, and accordingly, throughout the entire circuit. The present invention when utilised with a 400 Hz, 6 volt AC input signal achieves approximately 3 mv ripple, and performance consistency, from unit to unit, of 0.1 per cent for filter poles at 20 rad/sec and 50 rad/sec.

Furthermore, the present invention improves over the known series full wave circuit of Figure 2 by reducing the number of components and by incorporating both poles of filtering into a single operational amplifier system. This is accomplished with components which have multiple functions. The operational amplifier serves as an active one pole filter, buffers the output to supply a low source impedance, and acts as a current-to-voltage converter, whereby the first filter means sees a pure load resistance into a virtual ground.

The present invention entails the following advantages over current designs: lowest ripple per filter pole; lowest component count for its unit-to-unit performance consistency; lowest count of critical resistors for its consistency; reduced operational amplifier count for its consistency; and lower cost for its consistency.

Half-wave modulation apparatus in accordance with the present invention will now be described in greater detail, by way of example, with reference to the accompanying drawings, in which:-

Figure 1 is a schematic diagram of a shunt switch full wave demodulator of the prior art, to which reference has already been made,

Figure 2 is a schematic diagram of a series switch full wave demodulator of the prior art, again to which reference has already been made,

Figure 3 is a schematic diagram of a preferred embodiment of the invention,

Figure 4 is a voltage versus time graph of an AC voltage input signal,

Figure 5a is a voltage versus time graph of a first reference square wave signal,

Figure 5b is a voltage versus time graph of a second reference square wave signal,

Figure 6 is a voltage versus time graph of a signal appearing at the junction of a resistor and a drain of a field-effect transistor in the preferred embodiment of the invention, and

Figure 7 is a voltage versus time graph of a signal appearing at a junction of a resistor and a capacitor in the preferred embodiment of the invention.

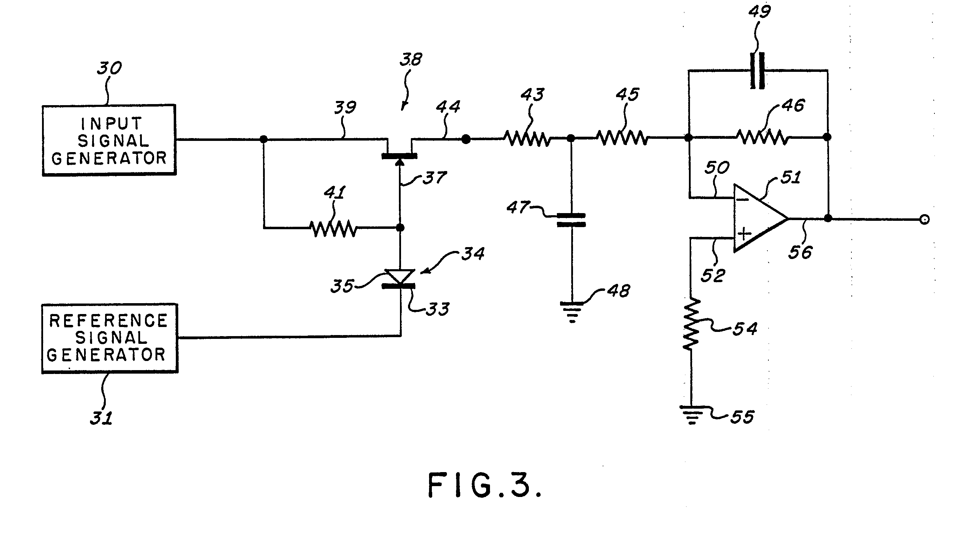

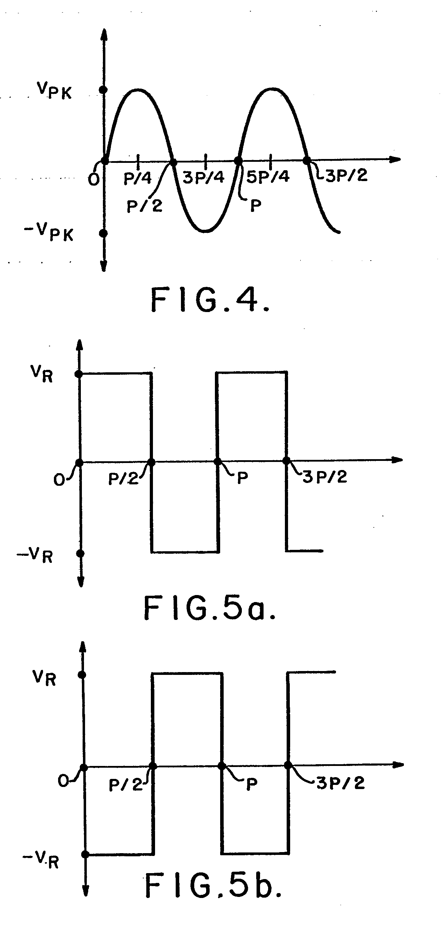

The present invention entails an electronic circuit for converting an AC voltage input signal to a DC voltage output signal. Referring to Figure 3, a preferred embodiment of the present invention is depicted. An AC voltage input signal generator 30 provides an AC voltage input signal having period P, and peak voltage $V_{PK}$, as illustrated in Figure 4. A reference square wave signal generator 31 provides a reference square wave signal, having a period P, whose axis crossings are synchronised with those of the AC voltage input signal. Referring to Figure 5a, the reference square wave signal may be positive when the AC voltage input signal is positive, and negative when the AC voltage input signal is negative, or alternatively, as in Figure 5b, negative when the AC voltage input signal is positive, and positive when the AC voltage input signal is negative. The reference square wave signal alternates every half period between $V_R$ and, preferably, $-V_R$. More generally, for an arbitrary, but fixed, period of the input signal, not necessarily coinciding with axis crossings, the reference square wave signal may be $V_R$ for half of the period and, preferably, $-V_R$ for the other half. For example, referring to Figure 4, the period of the AC input signal may be chosen to commence at $P/4$ and terminate at $5P/4$. The reference signal may then be $V_R$ during the half period $P/4$ to $3P/4$, and $-V_R$ for the half-period $3P/4$ to $5P/4$, or vice versa. A cathode 33 of a diode 34 is coupled to the reference square wave signal generator 31. An anode 35 of the diode 34 is coupled to a gate 37 of a field-effect transistor 38. A source 39 of the field-effect transistor 38 is coupled to the AC voltage input signal generator 30. A first end of a resistor 41 is coupled to the junction of the source 39 of the field-effect transistor 38 and the AC voltage input signal generator 30. The second end of the resistor 41 is coupled to the junction of the anode 35 of the diode 34 and the gate 37 of the field-effect transistor 38.

A first end of a resistor 43 is coupled to a drain 44 of the field effect transistor 38. The second end of the resistor 43 is coupled to a first end of a resistor 45. The second end of the resistor 45 is coupled to a first end of a resistor 46. A first end of a capacitor 47 is coupled to ground 48, and the second end of the capacitor 47 is coupled to the junction of the resistor 43 and the resistor 45. A first end of a capacitor 49 is coupled to the junction of the resistor 45 and the resistor 46, and the second end of the capacitor 49 is coupled to the second end of the resistor 46. An inverting input terminal 50 of an operational amplifier 51 is coupled to the junction of the resistor 45 and the resistor 46. A non-inverting input terminal 52 of the operational amplifier 51 is coupled to a first end of a resistor 54, the second end of which is coupled to ground 55. An output terminal 56 of the operational amplifier 51 is coupled to the second end of the resistor 46.

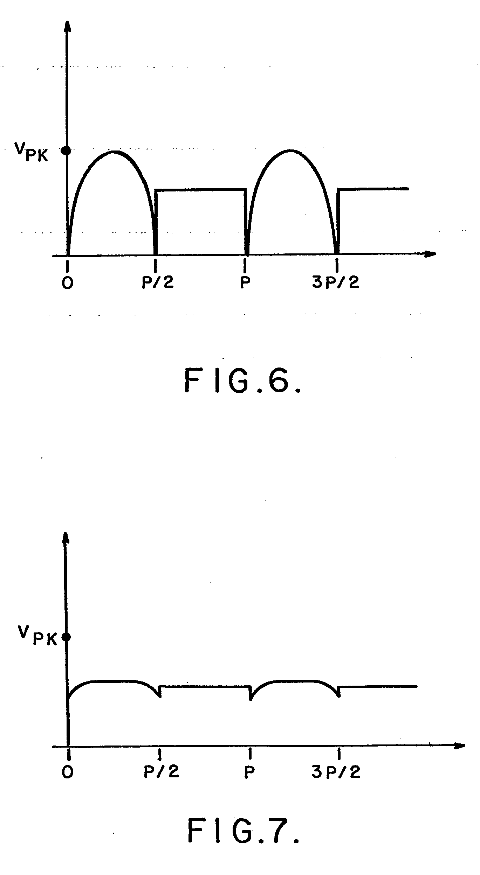

In operation, the AC voltage input signal generator 30 provides the AC voltage input signal illustrated in Figure 4. The reference square wave generator 31 provides a reference square wave signal which, relative to the AC voltage input signal, is preferably that of Figure 5a or that of Figure 5b. Wihtout loss of generality, the following description assumes a reference square wave signal which, relative to the AC voltage input signal, is as in Figure 5a. The voltage $V_R$ of the reference square wave signal is no less than the sum of the peak voltage $V_{PK}$ of the AC voltage input signal, the forward bias voltage of the diode 34, and the gate-to-source cut-off voltage of the filed-effect transistor 38. When the reference square wave signal of Figure 5a is positive, the diode 34 is reverse biased, and no current flows therethrough. There is no current flow through the junction of the gate and channel of the field-effect transistor 38. Accordingly, there is no current flow through the resistor 41, whereby the voltage of the AC voltage input signal appears at the gate 37 of the field-effect transistor 38. The three terminals of the field-effect transistor, that is the source 39, the gate 37, and the drain 44, are at the same voltage, whereby the field-effect transistor 38 is conducting. The AC voltage input signal appears, for a half-period, at the junction of the drain 44 of the field-effect transistor 38 and the resistor 43, as illustrated by the waveform in Figure 6 in the time interval 0 to P/2. Preferably, to reduce inaccuracies, the resistance of the resistor 43 is chosen to be approximately one-thousand times that of the field-effect transistor 38 when it is on. The resistor 43, the resistor 45 and the capacitor 47 form a filter which effects an averaging of the AC voltage input signal during this half-period. Thus, once steady-state is attained, the voltage that appears, during this half-period, at the junction of the resistor 43 and the capacitor 47 is $2/\pi$ of the peak voltage $V_{PK}$ of the AC voltage input signal. This waveform is depicted in Figure 7 in the time interval 0 to P/2.

Referring to Figure 5a, after the half-period wherein the reference square wave is $V_R$ volts, the wave becomes, preferably, $-V_R$ volts, for a half-period. During this half-period, from P/2 to P, the diode 34 is conducting. The resistor 41 is selected with a resistance sufficient to isolate the AC voltage input signal from the reference square wave signal. Accordingly, a voltage of approximately $-V_R$ appears on the gate 37 of the field-effect transistor 38. Since the difference between the voltage of the AC voltage input signal, which appears on the source 39, and the voltage $-V_R$ on the gate 37 is at least the gate-to-source cut-off voltage of the field-effect transistor 38, the field-effect transistor 38 is turned off during the half-period P/2 to P. No current flows through the resistor 43, and the voltage at the junction of the drain 44 of the field-effect transistor 38 and the resistor 43 is the voltage at the junction of the resistor 43 and the capacitor 47. This voltage, due to the filtering effect of the resistor 43, the resistor 45 and the capacitor 47, is essentially, as before $2/\pi$ of the peak voltage $V_{PK}$ of the AC voltage input signal. Figure 6 depicts this voltage at the junction of the drain 44 and the resistor 43 by the waveform in the interval P/2 to P. Similarly, Figure 7 depicts this voltage at the junction of the resistor 43 and the capacitor 47 by the waveform in the interval P/2 to P. Actually, due to current drainage through the resistor 45, this voltage declines exponentially but, in practice, it is essentially constant, owing to the small amount of time involved. Preferably, to reduce inaccuracies, the resistance of the resistor 45 is also chosen to be approximately one-thousand times that of the field-effect transistor 38 when it is on.

After the first period, the process begins again with the switching on of the field-effect transistor 38 by the positive square wave reference signal. Referring to Figure 6, the voltage appearing at the junction of the drain 44 and the resistor 43 during the interval P to 3P/2 is illustrated. This waveform is, of course, the same as that in the interval 0 to P/2. Similarly, referring to Figure 7, the voltage appearing at the junction of the resistor 43 and capacitor 47 during the interval P to 3P/2 is illustrated. This waveform is essentially a replica of the waveforms in the intervals 0 to P/2 and P/2 to P. In this fashion, the voltage appearing at the junction of the drain 44 and the resistor 43 consists of alternating, essentially identical, sinusoidal and square waveforms, each of duration P/2. The voltage appearing at the junction of the resistor 43 and the capacitor 47 consists of a substantially constant voltage, equal to $2/\pi$ of $V_{PK}$, having a degree of ripple

Preferably, the resistor 54 is selected to have a resistance which is equal to that of the resistor 46 in parallel with a resistor having a resistance equal to twice that of the resistor 43 plus that of the resistor 45. That is, if the resistance of the resistor 43 is $R_3$,

if the resistance of the resistor 45 is $R_4$, and if the resistance of the resistor 46 is $R_5$, then the resistance of the resistor 54 is chosen to be:-

$$R_5(2R_3 + R_4)/(2R_3 + R_4 + R_5)$$

This choice is predicated upon the fact that this is the Thornton equivalent resistance seen from the inverting input terminal 50 of the operational amplifier 51. By providing the same resistance at the non-inverting input terminal 52 as at the inverting input terminal 50, both terminals experience the same voltage drop which ensures that there is no output of the operational amplifier 51 due to bias current of the operational amplifier when there is no input to the circuit.

Since the non-inverting input terminal 52 of the operational amplifier 51 is coupled to ground 55, the voltage at the junction of the resistor 45 and the resistor 46 is virtually zero. The resistor 46 and the capacitor 49 form a second filter which further reduces the ripple appearing at the junction of the resistors 43 and 45. Accordingly, the voltage at the output terminal 56 of the operational amplifier 51 can be shown to be essentially a constant one, having a value:-

$$-(2/\pi)(R_5/(R_3 + R_4))V_{PK}$$

If, relative to the AC voltage input signal, the reference square wave signal is as depicted in Figure 5b, then the voltage at the output terminal 56 is the negative of the above. More generally, the voltage at the output terminal 56 can be shown to be:-

$$-(2/\pi)(R_5/(2R_3 + R_4)V_{PK} \cdot \cos(\theta)$$

where $\theta$ is the angle of the input signal relative to the reference signal.

The filter poles can be shown to be at:-

$$1/(2\pi R_5C_2) \text{ and } 1/(2\pi((2R_3R_4)/(2R_3 + R_4))C_1)$$

where $C_1$ and $C_2$ are, respectively, the capacitances of the capacitors 47 and 49.

## CLAIMS

1. Half-wave demodulation apparatus characterised in that it comprises means for generating an AC voltage input signal having a period comprising a first half period and a second half period; means (31, 34, 38, 41), having an input terminal coupled to the generating means and an output terminal, for switching off the AC voltage input signal during the first half period and for switching on the AC voltage input signal during the second half period; first means (43, 45, 47), having an output terminal and an input terminal coupled to the output terminal of the switching means, for filtering the input signal; second means (46, 49), having an input terminal coupled to the output terminal of the first filtering means and having an output terminal, for filtering the input signal; an operational amplifier (51) having an inverting input terminal coupled to the input terminal of the second filtering means, an output terminal coupled to the output terminal of the second filtering means, and a non-inverting input terminal; and a first resistor (54) having a resistance $R_1$, a first end coupled to the non-inverting input terminal and a second end coupled to ground.

2. Apparatus according to claim 1, characterised in that the switching means comprises a field-effect transistor (38) having a resistance $R_T$ when switched on, a source (39), a gate (37) and a drain (44), the input terminal of the switching means comprising the source, and the output terminal of the switching means comprising the drain; means (31) for generating a reference signal having a predetermined first voltage waveform during the first half period, and having a predetermined second voltage waveform during the second half period; a diode (34) having an anode (35) coupled to the gate (37) of the field-effect transistor (38) forming a first junction, and a cathode (33) coupled to the reference signal

- 11 -

generating means; and a second resistor (41) having a first end coupled to a junction of the input signal generating means (30) and the source (39), and a second end coupled to said first junction.

3. Apparatus according to claims 2, characterised in that the first filtering means comprises a third resistor (43) having a resistance $R_3$, a first end and a second end, the input terminal of the first filtering means comprising the first end of the third resistor; a capacitor (47) having a first end coupled to the second end of the third resistor forming a second junction, and a second end coupled to ground; and a fourth resistor (45) having a resistance $R_4$, a first end coupled to the second junction, and a second end which forms the output terminal of the first filtering means.

4. Apparatus according to claims 3, characterised in that the second filtering means comprises a fifth resistor (46) having a resistance $R_5$, a first end and a second end; and a capacitor (49) having a first end coupled to the first end of the fifth resistor to form a third junction, and a second end coupled to the second end of the fifth resistor to form a fourth junction, the input terminal of the second filtering means comprising the third junction, and the output terminal of the second filtering means comprising the fourth junction.

5. Apparatus according to claim 4, characterised in that $R_1$ is substantially equal to $R_5(2R_3 + R_4)/(2R_3 + R_4 + R_5)$.

6. Apparatus according to claim 5, characterised in that $R_3$ and $R_4$ are each substantially 1000 $R_T$.

7. Half-wave demodulation apparatus for use with means for generating an AC voltage input signal having a period comprising a first half period and a second half period, and for use with means for generating a reference signal, characterised in that the apparatus comprises means (34, 38, 41) having an output terminal, and having first and

0161896

- 12 -

second input terminals for coupling, respectively, to the input signal generating means (30) and the reference signal generating means (31), for switching off, in response to the reference signal, the AC voltage input signal during the first half period, and for, in response to the reference signal, switching on the AC voltage input signal during the second half period; first means (43, 45, 47) having an output terminal and an input terminal coupled to the output terminal of the switching means, for filtering the input signal; second means (46, 49) having an input terminal coupled to the output terminal of the first filtering means and having an output terminal, for filtering the input signal; an operational amplifier (51) having an inverting input terminal coupled to the input terminal of the second filtering means, an output terminal coupled to the output terminal of the second filtering means, and a non-inverting input terminal; and a first resistor (54) having a resistance $R_1$, a first end coupled to the non-inverting input terminal and a second end for coupling to ground.

8. Apparatus according to claim 7, characterised in that the reference signal comprises a predetermined first voltage waveform during the first half period, and a predetermined second voltage waveform during the second half period, and wherein the switching means comprises a field-effect transistor (38) having a resistance $R_T$ when switched on, a source (39), a gate (37), and a drain (44), the first input terminal of the switching means comprising the source; a diode (34) having an anode (35) coupled to the gate of the field-effect transistor forming a first junction, and a cathode (33) the second input terminal of the switching means comprising the cathode; and a second resistor (41) having a first end coupled to the source (39), and a second end coupled to the first junction.

9.   Apparatus according to claim 8, characterised in that the first filtering means comprises a third resistor (43) having a resistance $R_3$, a first end and a second end, the input terminal of the first filtering means comprising the first end of the third resistor; and a capacitor (47) having a first end coupled to the second end of the third resistor forming a second junction, and a second end for coupling to ground; and a fourth resistor (45) having a resistance $R_4$, a first end coupled to the second junction, and a second end, the output terminal of the first filtering means comprising the second end of the fourth resistor.

10.   Apparatus according to claim 9, characterised in that the second filtering means comprises a fifth resistor (46) having a resistance $R_5$, a first end and a second end; and a capacitor (49) having a first end coupled to the first end of the fifth resistor forming a third junction, and a second end coupled to the second end of the fifth resistor forming a fourth junction, the input terminal of the second filtering means comprising the third junction, and the output terminal of the second filtering means comprising the fourth junction.

11.   Apparatus according to claim 10, characterised in that the first resistor has a resistance $R_1$ substantially equal to $R_5(2R_3 + R_4)/(2R_3 + R_4 + R_5)$.

12.   Apparatus according to claim 11, characterised in that $R_3$ and $R_4$ are each substantially 1000 $R_T$.

FIG.1.

FIG.2.

INPUT SIGNAL GENERATOR

16

17

18

19

20

20a

14

REFERENCE SIGNAL GENERATOR

15

REFERENCE SIGNAL GENERATOR

0161896

FIG.3.

0161896

$V_{PK}$

$-V_{PK}$

O  P/4  3P/4  5P/4  3P/2
P/2  P

# FIG.4.

$V_R$

$-V_R$

O  P/2  P  3P/2

# FIG.5a.

$V_R$

$-V_R$

O  P/2  P  3P/2

# FIG.5b.

FIG.6.

FIG.7.